# FASCICULE DE BREVET EUROPEEN

(11) **EP 4 120 311 B1**
(45) Date de publication et mention de la délivrance du brevet: **28.02.2024**
(21) Numéro de dépôt: 22184283.4
(22) Date de dépôt: 12.07.2022
(51) Int. Cl.: H01H 83/14, G01R 31/52

(54) **COLMATAGE ACTIF DE FUITE DE COURANT**
AKTIVE ABDICHTUNG VON LECKSTROM
ACTIVE CLOGGING OF CURRENT LEAKAGE

(30) Priorité: 12.07.2021 FR 2107531
(43) Date de publication de la demande: 18.01.2023
(73) Titulaire: Dupuy, Philippe, 78112 Fourqueux (FR)
(72) Inventeur: Dupuy, Philippe, 78112 Fourqueux (FR)
(74) Mandataire: Rhein, Alain

(56) Documents cités:
- EP-A1- 0 320 409
- EP-A1- 3 199 959
- FR-A1- 3 073 330

## Description

**Domaine de l'invention** : L'invention concerne le domaine des installations électriques, de la distribution électrique, des infrastructures dotées d'équipements électriques et électroniques.

Le document FR 3 073 330 A1 divulgue un dispositif électronique selon le préambule de la revendication 1.

**Exposé de l'art antérieur** : Traditionnellement, la fraction de courant d'un équipement électrique circulant vers la terre, directement ou indirectement via le conducteur de protection dénommé PE pour `Protective Earth' ou encore appelé conducteur de terre, est surveillée par une protection différentielle placée en tête de ligne. La protection différentielle permet entre autres mesures, d'éviter une montée excessive du potentiel de l'enveloppe métallique des équipements reliés au conducteur de protection, prévenant ainsi le risque d'électrisation, encore appelé risque de choc électrique par contact indirect, pour un utilisateur amené à utiliser un équipement électrique à enveloppe métallique d'une installation comportant un appareil défectueux.

Les normes et règlementations en vigueur fixent selon les différents cas d'usage, les valeurs limites, les seuils des paramètres électriques ou encore leurs combinaisons admissibles au niveau des équipements et des protections au tableau ainsi qu'au niveau de l'installation et de sa liaison à la terre. A titre d'exemple, sont rappelés ci- après quelques-uns de ces paramètres ainsi que leurs valeurs usuelles :
- Limite de la valeur du courant de fuite de l'équipement (exemple : 5 mA)
- Seuil de disjonction de la protection différentielle (exemple : 30 mA)
- Limite de la valeur maximale de la tension de l'enveloppe par rapport à la terre (exemple : 50 Volts)
- Valeur maximale de la résistance de connexion du conducteur de protection à la terre (exemple : 100 ohms)
- etc....

Cette fraction de courant circulant vers la terre peut se décomposer en deux catégories ayant chacune une origine distincte : Le courant de fuite et le courant de défaut.

Le courant de fuite se caractérise par sa faible valeur et par sa présence continue en fonctionnement normal. Ce courant traduit souvent la présence de filtres électromagnétiques dans l'équipement ou encore un couplage capacitif entre un des composants de l'équipement et sa carcasse métallique.

A l'inverse du courant de fuite, le courant de défaut peut atteindre des valeurs très importantes. Apparaissant en situation anormale ou accidentelle, il se révèle lors de l'apparition d'un problème d'isolement dans un équipement électrique ou dans un faisceau de câbles. La pénétration d'eau induit souvent ce type de défaut.

Signalons également qu'un courant de défaut peut aussi apparaitre de façon intempestive en cas de contact direct comme le touché par l'utilisateur d'un conducteur électrique actif insuffisamment isolé. Afin de couvrir ce type de situation extrêmement critique, il est important de disposer d'une protection disposant d'une grande sensibilité ainsi que d'un délai de disjonction très faible, dans le but d'apporter la meilleure protection possible pour une personne qui serait ainsi exposée.

Les protections différentielles sont basées sur la mesure du courant dit « de mode commun », circulant simultanément sur la ou les phases et le neutre et se rebouclant vers la terre. De ce fait les protections ne font pas la différence entre le courant de fuite de l'équipement et un potentiel courant de défaut. De toute façon, l'un comme l'autre ayant le même effet sur la montée de potentiel du conducteur de protection PE, il est primordial de bien considérer la somme des deux types de courant au niveau de la protection différentielle. Ainsi, le courant d'une ligne électrique circulant vers la terre nécessite une action de surveillance continue allant jusqu'à provoquer la disjonction de la protection en cas de valeur excessive mesurée, entrainant alors la disparition rapide de la tension d'alimentation de la ligne.

Le courant de fuite d'un équipement seul, soumis à des normes strictes, se situe généralement bien au-dessous de la limite de disjonction de l'installation, alors que le courant de défaut peut prendre selon la nature du défaut des valeurs importantes provoquant le déclenchement de la protection différentielle.

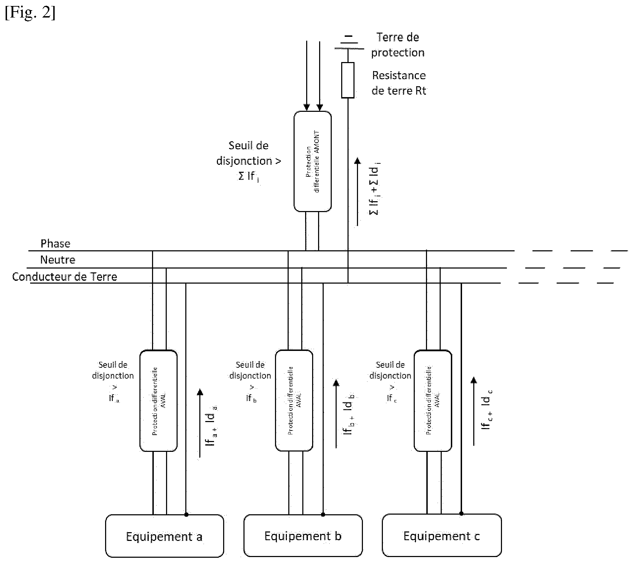

Dans le cas de plusieurs équipements connectés sur une même ligne de distribution comme illustré [Fig.2], le courant de fuite global résultant des différents équipements connectés et circulant dans le conducteur de protection PE peut prendre une valeur significative. Néanmoins cette valeur doit forcément rester limitée sous peine d'excéder le calibre du disjoncteur différentiel situé en tête de ligne. En effet, lorsque la somme des courants de fuite des équipements présents sur la ligne atteint la valeur de seuil de la protection différentielle de la ligne, la disjonction est inévitable entrainant la perte de service de l'installation alors qu'aucun défaut n'est pourtant à déplorer. Cet effet de cumul des courants de fuite limite par conséquent le nombre d'équipements présents sur une même ligne de distribution et impose un étagement des niveaux de sensibilité des protections différentielles. En effet, la prise en compte du cumul des courants de fuite de tous les équipements ou groupe d'équipements alimentés par la ligne d'alimentation, implique l'adoption d'une sensibilité de la protection différentielle dédiée à un seul équipement ou groupe d'équipements et située en amont dans le tableau électrique ou tableau général basse tension, inférieure à la sensibilité de la protection différentielle dédiée à un seul équipement ou groupe d'équipements et située en aval dans un tableau de distribution secondaire. Cet étagement des seuils entre l'amont et l'aval porte aussi le nom de « coordination ». Les obligations et contraintes qui en résultent pour l'installation sont :
- D'adopter une impédance de boucle de la liaison à la terre le plus faible possible, pouvant s'avérer à l'extrême incompatible avec un régime TT ou IT
- De limiter in fine le nbre d'équipements de l'installation dans le but d'éviter une augmentation trop importante du potentiel du conducteur de protection (PE)
- De renforcer les barrières de protection mécaniques de la ligne de distribution amont afin de réduire l'exposition des personnes au risque d'électrisation par contact direct, la sensibilité de la protection amont s'avérant trop faible pour assurer la couverture même partielle de ce risque.

**Objectifs de l'invention** : Le dispositif selon l'invention, assure le colmatage actif du courant de fuite d'un ou plusieurs équipement(s) électrique(s) présent(s) dans une installation électrique, en neutralisant la remontée de courant vers l'amont de l'installation, permettant ainsi de remédier aux obligations et contraintes exposées ci-avant à la section « exposé de l'état de l'art antérieur », en augmentant la disponibilité et la sécurité de l'installation en évitant la montée de potentiel du conducteur de protection PE ainsi qu'en renforçant la protection des utilisateurs en réduisant le seuil de disjonction du disjoncteur différentiel amont situé en tête de ligne de distribution.

**Avantages de l'invention** : L'invention concerne un dispositif électronique de colmatage des fuites de courant vers la terre d'un équipement ou d'un groupe d'équipements présent(s) dans une installation électrique. La calibration du seuil de disjonction de la protection différentielle d'une ligne de distribution dépend directement du nombre d'équipements connectés et plus particulièrement de la somme des courants de fuite de ces équipements. En effet, le seuil de disjonction de cette protection est sélectionné dans une plage de valeurs définie par un minimum correspondant à la somme des courants de fuite des équipements en fonctionnement normal et un maximum correspondant à la valeur maximale acceptable de courant déterminé par le rapport entre la valeur maximale de tension admissible pour le potentiel du conducteur de protection PE et la valeur de résistance de la liaison à la terre. Il peut arriver que les contraintes physiques, de sécurité ou règlementaires ne permettent pas de trouver de solution obligeant alors l'installateur à revoir son architecture de distribution et de protection en augmentant le nbre de protections différentielles et/ou de revoir à la baisse la résistance de liaison à la terre de l'installation quand c'est possible. Dans tous les cas, la protection de la ligne de distribution se trouve d'autant plus affectée que la somme des courants de fuite des équipements est élevée. De même, le potentiel du conducteur de protection augmente avec la valeur de la somme des courants de fuite

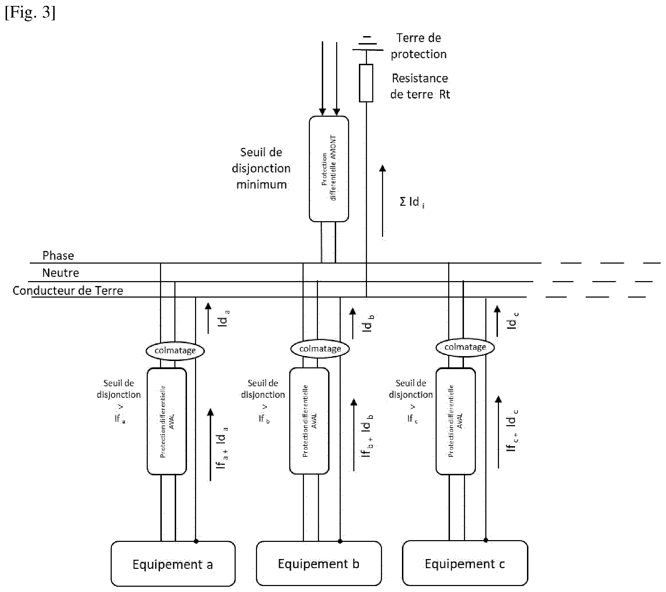

Pour remédier à ce problème, comme illustré en [Fig.3], l'invention décrit comment contenir l'effet de ce courant de fuite en le neutralisant localement totalement ou partiellement, évitant ainsi la montée de potentiel du conducteur de protection PE et limitant l'augmentation nécessaire du calibre du disjoncteur amont de l'installation. Nous appellerons cette neutralisation totale ou partielle, le colmatage actif de fuite de courant.

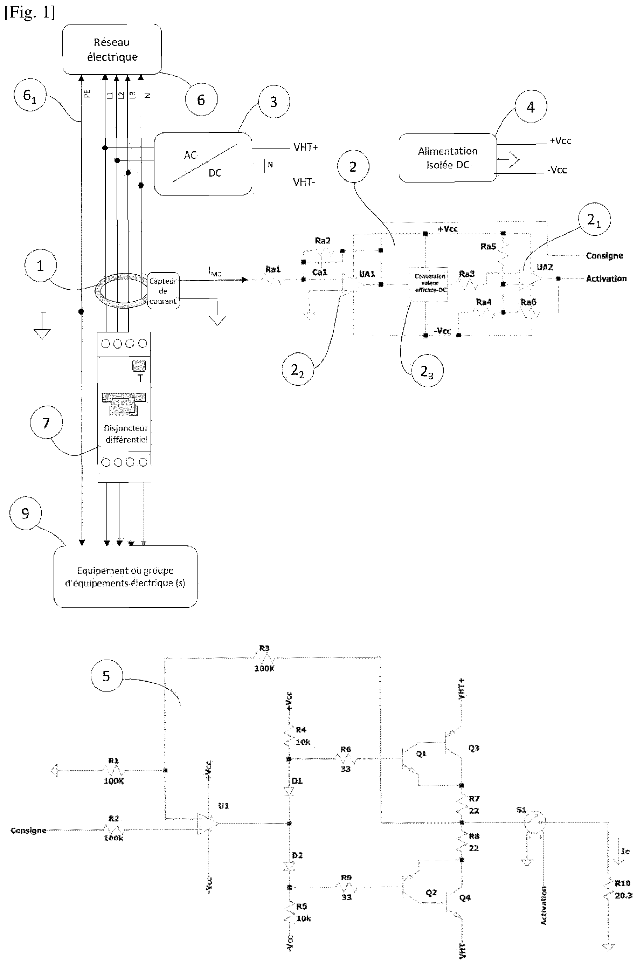

**Mode de réalisation préféré de l'invention** : Le dispositif électronique en [Fig.1] destiné à neutraliser le courant de fuite circulant à travers le conducteur de protection PE (6₁) d'un équipement ou groupe d'équipements électrique(s) quelconque(s) (9) monophasé(s), biphasé(s) ou triphasé(s), comprend un capteur de courant (1) englobant la ou les phase(s) et le neutre , une cellule de traitement et de filtrage (2) assurant la génération d'un signal de consigne nommé 'consigne' ainsi que la génération d'un signal d'activation nommé « activation ». Cette cellule de traitement et de filtrage (2) assure que la valeur de tension du signal de consigne soit proportionnelle au courant mesurée I_{MC} ou à sa valeur filtrée « consigne » selon un filtrage de type 'passe-bas'(2₂) et assure l'activation et la désactivation de la neutralisation du courant de fuite circulant à travers le conducteur de protection PE (6₁) selon l'amplitude du signal «consigne » par l'intermédiaire d'un comparateur à hystérésis (2₁). Le dispositif comprend également une alimentation de tension symétrique continue (3) non isolée dont l'entrée est connectée au réseau électrique (6) monophasé, biphasé ou triphasé et dont la sortie présente deux tensions continues symétriques nommées « V_{HT⁺} » et « V_{HT⁻} », de valeurs respectives +300 volts et -300 volts et référencées au neutre. Le dispositif comprend également une alimentation basse tension symétrique isolée (4), dont l'entrée est connectée au réseau électrique (6) et dont la sortie isolée présente 2 tensions « +V_{cc} » et « -V_{cc} », de valeurs respectives +15 volts et -15 volts et dont la masse de sortie est référencée au conducteur de protection PE (6₁). Le dispositif comprend enfin une cellule électronique d'injection du courant de colmatage « I_{c »} (5) vers le conducteur de protection PE (6₁). Ce courant de colmatage injecté « I_{c} » est asservi à la tension de consigne « consigne » par un étage d'amplification permettant de reproduire aux bornes de la résistance R₁₀ une valeur proportionnelle à cette tension d'entrée, par l'intermédiaire d'un montage amplificateur de classe AB, constitué d'un amplificateur opérationnel U1 en montage non inverseur alimenté entre « +V_{cc} » et « -V_{cc} » dont l'entrée positive est reliée au signal « consigne » par l'intermédiaire de la résistance R2 de valeur 100kohm , dont l'entrée négative est reliée au potentiel du conducteur de protection PE (6₁) par l'intermédiaire de la résistance R1 de 100kohm, dont la contre réaction est constituée par une résistance R3 de 100kohm reliant son entrée négative et le point milieu de l'étage push-pull de sortie constitué par la connexion entre les résistances R7 et R8 de vingt-deux ohms chacune et l'interrupteur S1, enfin dont la sortie dudit amplificateur opérationnel U1 est reliée d'une part à la cathode de la diode D1 dont l'anode est reliée au« +V_{cc} » par `l'intermédiaire d'une résistance R4 de 10 kohm et d'autre part à l'anode de la diode D2 dont la cathode est reliée au « -V_{cc} » par l'intermédiaire d'une résistance R5 de 10kohm, par un étage push-pull comportant quatre transistors bipolaires dont Q2 et Q3 sont de type PNP et Q1 et Q4 sont de type NPN, dont les paires Q1,Q3 et Q2,Q4 sont respectivement couplées selon un montage Sziclay caractérisé par le fait que le collecteur de Q1 et relié à la base de Q3 et par le fait que le collecteur de Q3 est relié à l'émetteur de Q1, et symétriquement par le fait que le collecteur de Q2 est relié à la base de Q4 et par le fait que le collecteur de Q4 est relié à l'émetteur de Q2, dont le collecteur de Q3 est relié au potentiel « V_{HT⁺} », dont le collecteur de Q4 est reliée au potentiel « V_{HT⁻} », dont la base de Q1 est reliée à l'anode de la diode D1 par l'intermédiaire de la résistance R6 de 33 ohm, dont la base de Q2 est reliée à la cathode de D2 par l'intermédiaire de la résistance R9 de 33 ohm, dont l'émetteur de Q1 et le collecteur de Q3 sont reliés au point milieu de sortie de l'étage push-pull par l'intermédiaire de la résistance R7 de 22 ohms, dont l'émetteur de Q2 et le collecteur de Q4 sont reliés au point milieu de sortie de l'étage push-pull par l'intermédiaire de la résistance R8 de 22 ohms, dont le point milieu de sortie de l'étage push-pull reliant R7,R8 et R3 est également connecté à l'entrée du relais S₁ et dont la résistance R10 de valeur 20,3 ohm a un de ses pôles relié à la sortie du relais S₁ et l'autre pôle relié au conducteur de protection PE (6₁), dont la bobine d'activation du relais S₁ a un de ses pôles relié au signal nommé « activation » et l'autre pôle relié au potentiel du conducteur de protection PE (6₁). La source d'énergie du courant de colmatage injecté « I_{c} » vers le potentiel du conducteur de protection PE (6₁) provient ainsi essentiellement des tensions d'alimentations « V_{HT⁺} » et « V_{HT⁻} » compte tenu des gains en courant importants procurés par les montages Sziclay de l'étage push-pull.

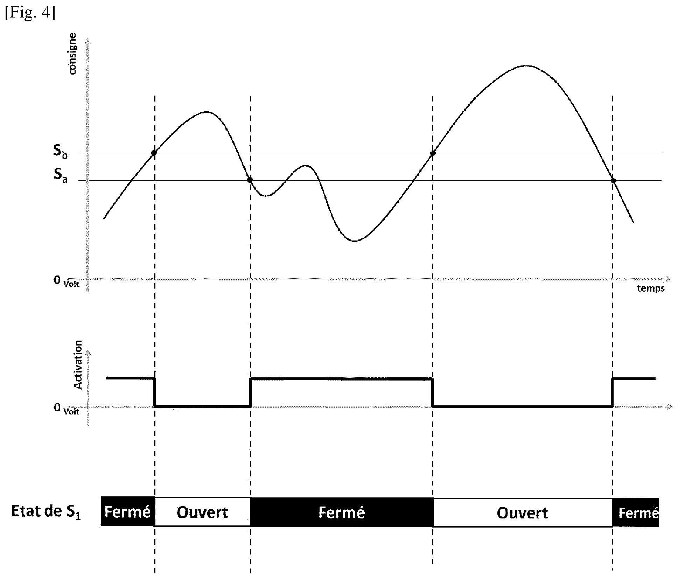

Au sein de la cellule de traitement et de filtrage (2), le signal de mesure I_{MC} issu du capteur de courant (1) est traité par le filtre passe-bas (22) en l'appliquant à l'entrée négative de l'ampli opérationnel Ua1 par l'intermédiaire de la résistance Ra 1, ampli Ua1 dont l'entrée positive est reliée au conducteur de protection PE (6₁) et dont la sortie est reliée à la résistance Ra2 et au condensateur Ca1 montés en contre-réaction vers son entrée négative. Le signal résultant « consigne » présent à la sortie de Ua1, est appliqué à un bloc de conversion assurant la transformation de sa valeur efficace en valeur continue proportionnelle, par l'utilisation par exemple du circuit intégré AD8436 ou d'un équivalent. La valeur continue résultante, image de la valeur efficace du signal « consigne » est appliquée à l'entrée négative du comparateur Ua2 par l'intermédiaire de la résistance Ra3, comparateur Ua2 dont l'entrée positive est reliée au pont diviseur constitué par Ra5 reliée au +Vcc et Ra4 reliée au potentiel du conducteur de protection PE (6₁) ainsi qu'à la résistance de réaction permettant l'hystérésis et reliée à sa sortie « activation ». Il en résulte deux seuils de basculement du comparateur nommés respectivement « Sₐ » et « S_{b} ». Comme indiqué sur la [Fig.4], l'injection du courant de colmatage « I_{c}» est activée par la fermeture du relais S₁ provoquée par l'apparition d'une tension sur sa commande « activation » lorsque l'amplitude efficace de la valeur filtrée « consigne » du courant mesuré (1), passe au-dessous du seuil « Sₐ », et désactivée par l'ouverture du relais S₁ provoquée par la disparition de tension sur sa commande « activation » lorsque l'amplitude efficace de la valeur filtrée « consigne » du courant mesuré (1) passe au-dessus d'un seuil « S_{b} »

La valeur de tension « V_{HT⁺} » de 300 volts est déterminée de façon à rester supérieure au potentiel maximum du conducteur de protection PE (6₁) et la valeur de tension « V _{HT}» de -300 volts est déterminée de façon à rester inférieure au potentiel minimum du conducteur de protection PE (6₁), autrement dit, la valeur absolue de l'amplitude crête de la tension entre le neutre et le conducteur de protection PE (6₁) n'excède pas 300 volts.

Une variante du dispositif consiste à rajouter un disjoncteur différentiel additionnel (7) situé entre le capteur de courant (1) et l'équipement ou groupe d'équipements électrique(s) quelconque(s) (6)

Une autre variante du dispositif consiste à rajouter un disjoncteur différentiel additionnel (7) entre le réseau électrique (6) en amont du capteur de courant (1) et de l'alimentation symétrique isolée (3)

Une autre variante du dispositif consiste à placer le capteur de courant (1) de telle sorte que soit mesuré uniquement le courant traversant le conducteur de protection PE (6₁) relié à l'équipement ou au groupe d'équipements électrique(s) (9). Dans ce cas, la liaison du dispositif au conducteur de protection PE (6₁) s'effectue en amont du capteur de courant (1), vers le réseau électrique (6), de sorte que le courant de colmatage « I_{c »} ne soit pas mesuré par le capteur de courant (1).

## Revendications

1. Dispositif électronique, comprenant un capteur de courant (1) englobant la ou les phase(s) et le neutre d'un réseau électrique (6) monophasé, biphasé ou triphasé alimentant un équipement électrique ou groupe d'équipements électriques (9), une cellule de traitement et de filtrage (2) assurant la génération d'un signal de consigne ainsi que l'ordre d'activation de la génération de ce courant et assurant que la valeur de tension de son signal de consigne soit proportionnelle au courant mesuré I_{MC} ou à sa valeur filtrée selon un quelconque filtrage, comprenant également une alimentation de tension symétrique continue (3) non isolée dont l'entrée est connectée au réseau électrique (6) monophasé , biphasé ou triphasé et dont la sortie présente deux tensions continues symétriques nommées 'V_{HT⁺}' et 'V_{HT⁻}', dont la masse de sortie est référencée soit au neutre, soit à une des phases soit à une tension résultant d'une combinaison entre la (les) phase(s) et le neutre, comprenant également une alimentation basse tension symétrique isolée (4), dont l'entrée est connectée au réseau électrique (6) ou aux tensions continues 'V_{HT⁺}' et 'V_{HT⁻} et dont la sortie isolée présente deux tensions '+V_{cc}' et '-V_{cc}' et dont la masse de sortie est référencée au conducteur de protection PE (6₁), comprenant également une cellule électronique d'injection du courant de colmatage 'I_{c}' (5) vers le conducteur de protection PE (6₁) dont le courant de colmatage injecté 'I_{c}' est asservi à sa tension d'entrée par un étage d'amplification permettant de reproduire aux bornes de la résistance R₁₀ une valeur proportionnelle à cette tension d'entrée, par l'intermédiaire d'un montage amplificateur, constitué d'au moins un amplificateur opérationnel possiblement complété par un étage push-pull comportant au moins deux transistors de polarité opposée ou comportant des transistors bipolaires reliés deux à deux selon un montage Darlington ou Sziclay, **caractérisé en ce que** la sortie de consigne de la cellule de traitement et de filtrage' (2) soit reliée à la tension d'entrée « consigne » de la cellule électronique (5) d'injection du courant de colmatage « I_{c »} et **en ce que** la source d'énergie du courant de colmatage injecté vers le potentiel de terre provient en totalité ou en partie des tensions d'alimentations 'V_{HT⁺}' et `V _{HT⁻}'

2. Dispositif suivant la revendication 1 **caractérisé en ce que** l'injection du courant de colmatage « I_{c »} est activée par la fermeture du relais S₁ lorsque l'amplitude du courant mesuré (1) ou de sa valeur filtrée selon un quelconque filtre, n'excède pas un seuil 'Sₐ', et désactivée par l'ouverture du relais S₁ lorsque l'amplitude du courant mesuré excède un seuil 'S_{b}'

3. Dispositif suivant la revendication 1 **caractérisé en ce que** la valeur de tension 'V_{HT⁺}' est déterminée pour être toujours supérieure au potentiel maximum du conducteur de protection PE (6₁) et **en ce que** la valeur de tension 'V_{HT⁻} est déterminée pour être toujours inférieure au potentiel minimum conducteur de protection PE (6₁),

4. Dispositif suivant la revendication 1 **caractérisé en ce qu'**un disjoncteur différentiel additionnel (7) est rajouté et connecté entre le capteur de courant (1) et l'équipement ou groupe d'équipements électrique(s) quelconque(s) (9)

5. Dispositif suivant la revendication 1 **caractérisé en ce qu'**un disjoncteur différentiel additionnel (7) est rajouté et relié au réseau électrique (6) en amont du capteur de courant (1) et de l'alimentation symétrique isolée (3)

6. Dispositif suivant la revendication 1 **caractérisé en ce que** le capteur de courant (1) est placé sur la liaison du conducteur de protection PE (6₁) à l'équipement ou groupe d'équipements électrique(s) (9)

7. Ensemble **caractérisé en ce que** plusieurs dispositifs selon la revendication 1 sont associés à plusieurs équipements ou groupes d'équipements électriques (9) alimentés par le réseau électrique (6)

## Patentansprüche

1. Elektronische Vorrichtung, umfassend einen Stromsensor (1), der die Phase(n) und den Nullleiter eines einphasigen, zweiphasigen oder dreiphasigen Elektrizitätsnetzes (6) beinhaltet, das eine elektronische Ausrüstung oder eine Gruppe von elektronischen Ausrüstungen (9) versorgt, eine Verarbeitungs- und Filtrationszelle (2), die die Erzeugung eines Sollsignals sowie die Aktivierungsreihenfolge der Erzeugung dieses Stroms sicherstellt und sicherstellt, dass der Spannungswert ihres Sollsignals proportional zu dem gemessenen Strom I_{MC} oder zu seinem gemäß einer beliebigen Filtration gefilterten Wert ist, umfassend außerdem eine nicht isolierte symmetrische Gleichspannungsversorgung (3), deren Eingang an das einphasige, zweiphasige oder dreiphasige Elektrizitätsnetz (6) angeschlossen ist und deren Ausgang zwei symmetrische Gleichspannungen aufweist, die "V_{HT⁺}" und "V_{HT⁻}" genannt werden, deren Ausgangsmasse sich entweder auf den Nullleiter oder auf eine der Phasen oder auf eine Spannung bezieht, die sich aus einer Kombination aus der/den Phase(n) und dem Nullleiter ergibt, umfassend außerdem eine isolierte symmetrische Niederspannungsversorgung (4), deren Eingang an das Elektrizitätsnetz (6) oder an die Gleichspannungen "V_{HT⁺}" und
"V_{HT⁻}" angeschlossen ist und deren isolierter Ausgang zwei Spannungen "+V_{cc}" und "-V_{cc}" aufweist und deren Ausgangsmasse sich auf den Schutzleiter PE (6₁) bezieht, umfassend außerdem eine elektronische Zelle zum Injizieren des Abdichtungsstroms "I_{c}" (5) in Richtung des Schutzleiters PE (6₁), deren injizierter Abdichtungsstrom "I_{c}" auf seine Eingangsspannung durch eine Verstärkungsstufe geregelt wird, die es ermöglicht, an den Klemmen des Widerstands R₁₀ einen Wert proportional zu dieser Eingangsspannung zu reproduzieren, über eine Verstärkerschaltung, bestehend aus mindestens einem betriebsfähigen Verstärker, der möglicherweise durch eine Gegentaktstufe vervollständigt wird, die mindestens zwei Transistoren mit entgegengesetzter Polarität vorweist oder bipolare Transistoren vorweist, die gemäß einer Darlington- oder Sziklai-Schaltung paarweise verbunden sind,
**dadurch gekennzeichnet, dass** der Sollausgang der Verarbeitungs- und Filtrationszelle (2) mit der "Soll"-Eingangsspannung der elektronischen Zelle (5) zum Injizieren des Abdichtungsstroms "I_{c}" verbunden ist, und **dass** die Energiequelle des injizierten Abdichtungsstroms in Richtung des Erdpotenzials vollständig oder teilweise von den Versorgungsspannungen "V_{HT⁺}" und "V_{HT⁻}" stammt.

2. Vorrichtung nach Anspruch 1, **dadurch gekennzeichnet, dass** das Injizieren des Abdichtungsstroms "I_{c}" durch die Schließung des Relais S₁ aktiviert wird, wenn die Amplitude des gemessenen Stroms (1) oder seines gemäß einem beliebigen Filter gefilterten Werts einen Schwellenwert "Sₐ" nicht überschreitet, und durch die Öffnung des Relais S₁ deaktiviert wird, wenn die Amplitude des gemessenen Stroms einen Schwellenwert "S_{b}" überschreitet.

3. Vorrichtung nach Anspruch 1, **dadurch gekennzeichnet, dass** der Spannungswert "V_{HT⁺}" bestimmt wird, um immer über dem maximalen Potenzial des Schutzleiters PE (6₁) zu sein, und **dass** der Spannungswert "V_{HT⁻}" bestimmt wird, um immer unter dem minimalen Potenzial des Schutzleiters PE (6₁) zu sein.

4. Vorrichtung nach Anspruch 1, **dadurch gekennzeichnet, dass** ein zusätzlicher Fehlerstromschutzschalter (7) zwischen dem Stromsensor (1) und der beliebigen elektrischen Ausrüstung oder Gruppe von elektrischen Ausrüstungen (9) hinzugefügt und angeschlossen wird.

5. Vorrichtung nach Anspruch 1, **dadurch gekennzeichnet, dass** ein zusätzlicher Fehlerstromschutzschalter (7) zu dem Elektrizitätsnetz (6) stromaufwärts des Stromsensors (1) und der isolierten symmetrischen Versorgung (3) hinzugefügt und damit verbunden wird.

6. Vorrichtung nach Anspruch 1, **dadurch gekennzeichnet, dass** der Stromsensor (1) auf der Verbindung des Schutzleiters PE (6₁) zu der elektrischen Ausrüstung oder der Gruppe von elektrischen Ausrüstungen (9) platziert ist.

7. Anordnung, **dadurch gekennzeichnet, dass** mehrere Vorrichtungen nach Anspruch 1 mehreren elektrischen Ausrüstungen oder Gruppen von elektrischen Ausrüstungen (9) zugeordnet sind, die durch das Elektrizitätsnetz (6) versorgt werden.

## Claims

1. Electronic device comprising a current sensor (1), which encompasses the phase(s) and the neutral of a single-phase, two-phase or three-phase electrical network (6) supplying a piece of electrical equipment or group of pieces of electrical equipment (9), a processing and filtering cell (2), which ensures the generation of a setpoint signal as well as the order of activation of the generation of this current and ensures that the voltage value of its setpoint signal is proportional to the measured current I_{MC} or to its filtered value according to any filtering, also comprising a non-isolated symmetrical DC voltage power supply (3), the input of which is connected to the single-phase, two-phase or three-phase electrical network (6) and the output of which has two symmetrical DC voltages named "V_{HT⁺}" and "V_{HT⁻}" and of which the output ground is referenced either to the neutral or to one of the phases or to a voltage resulting from a combination between the phase(s) and the neutral, also comprising an isolated symmetrical low-voltage power supply (4), the input of which is connected to the electrical network (6) or to the DC voltages "V_{HT⁺}" and "V_{HT⁻}" and the isolated output of which has two voltages "+V_{cc}" and "-V_{cc}" and of which the output ground is referenced to the protection conductor PE (6₁), also comprising an electronic cell for injecting the plugging current "I_{c}" (5) toward the protection conductor PE (6₁), of which the injected plugging current "I_{c}" is slaved to its input voltage by an amplification stage which makes it possible to reproduce, at the terminals of the resistor R₁₀, a value proportional to this input voltage via an amplifier arrangement consisting of at least one operational amplifier which is optionally completed by a push-pull stage including at least two transistors of opposite polarity or including bipolar transistors which are connected in pairs according to a Darlington or Sziklai arrangement, **characterized in that** the setpoint output of the processing and filtering cell (2) is connected to the "setpoint" input voltage of the electronic cell (5) for injecting the plugging current "I_{c}", and **in that** the energy source of the plugging current injected toward the earth potential originates in whole or in part from the supply voltages "V_{HT⁺}" AND "V_{HT⁻}".

2. Device according to claim 1, **characterized in that** injecting the plugging current "I_{c}" is activated by closing the relay S₁ when the amplitude of the measured current (1) or its filtered value according to any filter does not exceed a threshold "Sₐ" and is deactivated by opening the relay S₁ when the amplitude of the measured current exceeds a threshold "S_{b}".

3. Device according to claim 1, **characterized in that** the voltage value "V_{HT}⁺" is determined to be always more than the maximum potential of the protection conductor PE (6₁), and **in that** the voltage value "V_{HT⁻}" is determined to be always less than the protection conductor PE (6₁) minimum potential.

4. Device according to claim 1, **characterized in that** an additional differential circuit breaker (7) is added and connected between the current sensor (1) and the piece of electrical equipment or group of any piece(s) of electrical equipment (9).

5. Device according to claim 1, **characterized in that** an additional differential circuit breaker (7) is added and connected to the electrical network (6) upstream of the current sensor (1) and the isolated symmetrical power supply (3).

6. Device according to claim 1, **characterized in that** the current sensor (1) is placed at the connection of the protection conductor PE (6₁) to the piece of electrical equipment or group of piece(s) of electrical equipment (9).

7. Assembly, **characterized in that** a plurality of devices according to claim 1 are associated with a plurality of pieces of electrical equipment or groups of pieces of electrical equipment (9) powered by the electrical network (6).
